**Europäisches Patentamt**

**European Patent Office**

**Office européen des brevets**

(19)

(11) Veröffentlichungsnummer: **0 489 196 A1**

# EUROPÄISCHE PATENTANMELDUNG

(12)

(21) Anmeldenummer: **90123360.1**

(22) Anmeldetag: **05.12.90**

(51) Int. Cl.5: **H03H 9/145**, H03H 9/64

(43) Veröffentlichungstag der Anmeldung:
**10.06.92 Patentblatt 92/24**

(84) Benannte Vertragsstaaten:
**AT BE CH DE DK ES FR GB GR IT LI LU NL SE**

(71) Anmelder: **SIEMENS MATSUSHITA COMPONENTS GmbH & CO KG Balanstrasse 73 W-8000 München 80(DE)**

(72) Erfinder: **Rott, Karlheinz, Dipl.-Math. Theresienstrasse 43 W-8000 München 40(DE)** Erfinder: **Schott, Wilfried, Dipl.-Math.**

**Edelweissstrasse 40 W-8034 Germering(DE)** Erfinder: **Zibis, Peter, Dipl.-Ing. Niemöller Allee 19 W-8000 München 83(DE)** Erfinder: **Ehrmann-Falkenau, Ekkehard, Dr.-Ing. verstorben /(DE)**

(74) Vertreter: **Fuchs, Franz-Josef, Dr.-Ing. et al Postfach 22 13 17 W-8000 München 22(DE)**

(54) **Elektrisches Oberflächenwellenfilter.**

(57) Elektrisches Oberflächenwellenfilter mit plättchenförmigem Substrat (1) aus einkristallinem, piezoelektrischen Werkstoff, dessen eine Substratseite zur Anregung und Auskopplung der Oberflächenwellen Interdigitalwandler (IW3, IW2) mit metallischen, kammartig ineinandergreifenden Elektrodenfingern (4, 5) und mit Sammelschienen (7, 15) bzw. (8, 9) trägt, wobei jeweils die Elektrodenfinger gleicher Polarität eine diesen Elektrodenfingern gemeinsame Sammelschiene kontaktieren. Mindestens eine Sammelschiene (15) eines Interdigitalwandlers (IW3) verläuft dabei wenigstens abschnittsweise sägezahnförmig und ist in diesem Abschnitt unter einem Winkel von ca. ± 10° bis ± 20° zur gewünschten Ausbreitungsrichtung der Oberflächenwellen geneigt.

## FIG 3

Die Erfindung betrifft ein elektrisches Oberflächenwellenfilter mit einem plättchenförmigen Substrat aus einkristallinem, piezoelektrischem Werkstoff, dessen eine Substratseite zur Anregung und Auskopplung der Oberflächenwellen Interdigitalwandler mit metallischen, kammartig ineinandergreifenden Elektrodenfingern und mit Sammelschienen trägt, wobei jeweils die Elektrodenfinger gleicher Polarität eine diesen Elektrodenfingern gemeinsame Sammelschiene kontaktieren.

Oberflächenwellenfilter sind z. B. durch das Datenbuch "Oberflächenwellenfilter für Fernsehanwendungen", Datenbuch 1989/90, Herausgeber Siemens, bekannt. Sie stellen integrierte, passive Bauelemente mit Bandfiltercharakteristik dar, deren Funktion auf der Interferenz von mechanischen Oberflächenwellen beruht, die sich längs der Oberfläche eines piezoelektrischen Materials ausbreiten. Ihr Aufbau ist durch ein einkristallines, piezoelektrisches Substrat, z. B. aus Lithiumniobat oder Lithiumtantalat, gekennzeichnet, auf das eine Metallschicht, z.B. Aluminiumschicht, aufgetragen, z. B. aufgedampft ist, aus der mittels Fotoätztechnik piezoelektrische Ein- und Ausgangswandler, sogenannte Interdigitalwandler herausgearbeitet sind. Diese bestehen aus mehreren metallisierten kammartigen Elektroden, d.h. aus Elektroden, bestehend aus Sammelschienen und senkrecht zu diesen ausgerichteten und jeweils mit den Sammelschienen gleicher Polarität kontaktierten Elektrodenfingern, die sich in den aktiven Bereichen der Wandler jeweils mit Elektrodenfingern der Elektroden unterschiedlicher Polarität überlappen. Das Substrat selbst ist üblicherweise auf einen Metallträger aufgeklebt. Die Kontaktierung der Ein- und Ausgangswandler mit den nach außen führenden Anschlüssen erfolgt dabei über Bond-Drähte.

Im Betrieb dieser Oberwellenflächenfilter wird ein in den Eingangswandler eingegebenes elektrisches Signal in eine mechanische Oberflächenwelle umgewandelt, die auf bzw. in der Oberfläche des Substrats zum Ausgangswandler läuft, der die Oberflächenwelle schließlich in ein durch die Charakteristik des Filters geprägtes elektrisches Signal rückverwandelt. Die vorstehend bereits erwähnten üblichen Wandler besitzen Interdigitalstrukturen mit Laufzeiteffekten, die mit einer Struktur zur Abschirmung versehen sein können. Sie haben stark frequenzabhängige Eigenschaften, so daß aufgrund der Ausbildung der Strukturen eine Filterwirkung für elektrische Signale erreichbar ist.

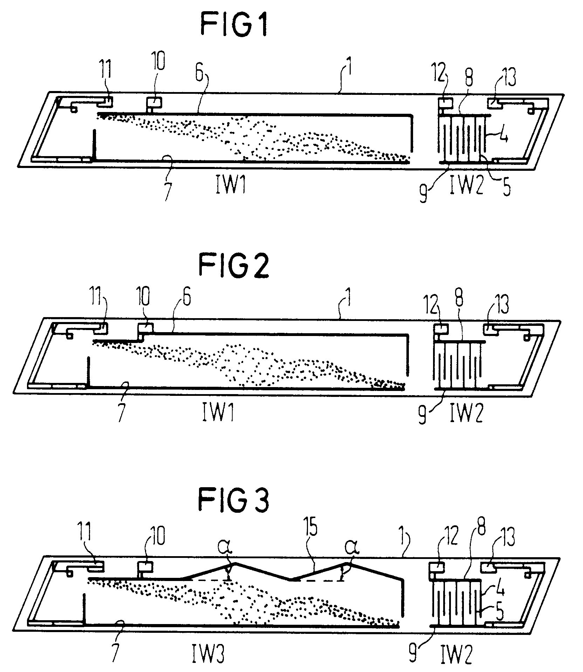

Die in den Überlappungsbereichen der Elektrodenfinger der Interdigitalwandler angeregten Wellen breiten sich nicht nur in der gewünschten Fortpflanzungsrichtung aus. Bei ihrer Ausbreitung treten nämlich Beugungseffekte auf, die dazu führen, daß Signale vom Eingangswandler nicht nur auf direktem Weg zum Ausgangswandler gelangen, sondern schräg laufende Wellen an den transversalen Berandungen bzw. Substratlängskanten der Wandler reflektiert und auf diesem Umweg zum Ausgangswandler geführt werden. Bei einem typischen Fernseh-ZF-Filter mit langem Eingangswandler und kurzem Ausgangswandler, wie es in FIG 1 gezeigt ist und später näher erläutert wird, findet die störende Reflexion am Eingangswandler statt. Dieser Effekt läßt sich durch Rechnerprogramme nur schlecht beschreiben und führt vor allem bei Filtern mit kleiner Apertur zu teilweise sehr störenden Abweichungen vom Design.

Soweit Oberflächenwellenfilter mit relativ großen Aperturen verwendet wurden, war dieser Effekt von geringerer Bedeutung, weshalb sich ohne spezielle Maßnahmen gegen diese Reflexion gute Oberflächenwellenfilter entwickeln ließen.

Eine Maßnahme gegen diesen störenden Beugungseffekt bot auch die Verlagerung der Sammelschienen der Wandler bis nahe an den Chip - bzw. Substratrand - siehe das Oberflächenwellenfilter gemäß FIG 2, das sich gegenüber dem Filter nach FIG 1 lediglich durch diese Maßnahme unterscheidet - , wobei mit dieser Maßnahme, die nur teils erfüllte Hoffnung verbunden war, daß in diesem Fall die reflektierte Welle am Ausgangswandler vorbeiläuft.

Der vorliegenden Erfindung liegt die Aufgabe zugrunde, ein Oberflächenwellenfilter zu schaffen, das so gestaltet ist, daß die vorstehend erläuterten störenden Reflexionen in einfachster und wirkungsvoller Weise unterdrückt werden.

Zur Lösung dieser Aufgabe sieht die Erfindung bei einem Oberflächenwellenfilter gemäß Oberbegriff des Patentanspruchs 1 vor, daß mindestens eine Sammelschiene eines Interdigitalwandlers wenigstens abschnittsweise sägezahnförmig verläuft und die Sammelschiene in diesem Abschnitt unter einem Winkel von ca. ± 10° bis ca. ± 20° C zur gewünschten Ausbreitungsrichtung der Oberflächenwellen bzw. zu den Substratlängskanten geneigt ist.

Bevorzugt beträgt dabei die Neigung der Sammelschiene in ihrem sägezahnförmigen Abschnitt ca. ± 16° zur gewünschten Ausbreitungsrichtung der Oberflächenwellen.

Die vorliegende Erfindung beruht letztlich darauf, daß die störende Reflexion durch die Unstetigkeit der Oberflächenwellengeschwindigkeit am Übergang von der Wandlergeometrie zur freien Substratfläche hervorgerufen wird. Für einen Einfallswinkel kleiner etwa ± 16° tritt dabei bei OFW-Filtern, bestehend aus $LiNbO_3$ -Kristall mit rotiertem Schnitt, Totalreflexion ein (Übergang vom dichteren ins dünnere Medium); bei größeren Winkeln nimmt die Reflektivität hingegen sehr rasch ab.

Die Erfindung wird nachstehend anhand von Ausführungsbeispielen näher erläutert. Es zeigt:

FIG 1     in schematischer und vereinfachter Darstellung eine Draufsicht auf ein Ausführungsbeispiel eines bekannten OFW-Filters

FIG 2     in der Darstellung nach FIG 1 ein zweites Ausführungsbeispiel eines an sich bekannten OFW-Filters

FIG 3     gleichfalls in der Darstellung nach FIG 1 eine Draufsicht auf ein OFW-Filter nach der Erfindung.

In sämtlichen Ausführungsbeispielen sind dabei gleiche Teile mit gleichen Bezugszeichen bezeichnet.

Die elektrischen Oberflächenwellenfilter, im folgenden kurz OFW-Filter genannt, gemäß den Ausführungsbeispielen nach den FIG 1 bis 3 besitzen jeweils ein plättchenförmiges Substrat 1 aus einkristallinem piezoelektrischen Werkstoff, insbesondere Lithiumniobat oder Lithiumtantalat. Dessen eine Substratseite trägt zur Anregung und Auskopplung der Oberflächenwellen Interdigitalwandler IW1 bzw. IW3 (siehe FIG 3) und IW2. Beide Interdigitalwandler bestehen aus z. B. auf das Substrat aufgedampften metallische Strukturen, deren Elektroden kammartig gestaltet sind und sich in den aktiven Interdigitalwandler-Bereichen mit ihren Elektrodenfingern - siehe z. B. die Elektrodenfinger 4, 5 der Ausgangswandler IW2 - überlappen. Die Elektrodenfinger der Interdigitalwandler sind dabei jeweils an Sammelschienen 6, 7 bzw. 7, 15 der Eingangswandler IW1 bzw. IW3 und an Sammelschienen 8, 9 der Ausgangswandler IW2 angeschaltet, welche wiederum an Kontaktflächen 10, 11 bzw. 12, 13 liegen.

Beim Fernseh-ZF-Filter nach FIG 1 mit langem Eingangswandler IW1 und kurzem Ausgangswandler IW1 finden aus den bereits eingangsgenannten Gründen die störenden Reflexionen am Eingangswandler statt.

Das Filter gemäß FIG 2 unterscheidet sich vom Filter nach FIG 1 durch die relativ große Apertur seines Eingangswandlers IW1, dessen Sammelschiene 6 näher zur Substratlängskante angeordnet ist. Bedingt durch die größere Apertur des Eingangswandlers IW1 stellt diese Ausführungsform den Versuch dar, die störende reflektierte Welle am Ausgangswandler IW2 vorbeizuführen.

Es hat sich jedoch gezeigt, daß erst durch die erfindungsgemäße Ausführungsform nach FIG 3 eine auch hinsichtlich ihres Aufwandes befriedigende Lösung, d.h. Unterdrückung der störenden Reflexion erreichbar ist. Hierzu ist es lediglich erforderlich, daß mindestens eine Sammelschiene - im gezeigten Ausführungsbeispiel die Sammelschiene 15 - eines Interdigitalwandlers wenigstens abschnittsweise sägezahnförmig verläuft und die Sammelschiene in diesem Abschnitt unter einem Winkel α von ca. ± 10° bis ± 20° zur gewünschten Ausbreitungsrichtung der Oberflächenwellen bzw. zur Substratlängskante geneigt ist.

Es hat sich erwiesen, daß diese Struktur die störende Reflexion in ausreichendem Maße unterdrückt. Die Sammelschiene 15 des Eingangswandlers IW3 ist dort abschnittsweise in einem Winkel von etwa ± 16° zur Ausbreitungsrichtung der Oberflächenwellen geneigt, wodurch es für die Oberflächenwellen keine Richtung mehr gibt, um mittels Totalreflexion vom Eingangswandler zum Ausgangswandler zu gelangen.

Abschließend sei nur erwähnt, daß die Winkel der einzelnen Sägezähne nicht zwingend symmetrisch zueinander sein müssen.

## Patentansprüche

1.   Elektrisches Oberwellenflächenfilter mit einem plättchenförmigen Substrat aus einkristallinem piezoelektrischen Werkstoff, dessen eine Substratseite zur Anregung und Auskopplung der Oberflächenwellen Interdigitalwandler mit metallischen, kammartig ineinandergreifende Elektrodenfingern und mit Sammelschienen trägt, wobei jeweils die Elektrodenfinger gleicher Polarität eine diesen Elektrodenfingern gemeinsame Sammelschiene kontaktieren,
**dadurch gekennzeichnet,**
daß mindestens eine Sammelschiene (15) eines Interdigitalwandlers (IW3) wenigstens abschnittsweise sägezahnförmig verläuft und die Sammelschiene in diesem Abschnitt unter einem Winkel von ca. ±10° bis ± 20° zur gewünschten Ausbreitungsrichtung der Oberflächenwellen bzw. zur Substratlängskante geneigt ist.

2.   Elektrisches Oberwellenflächenfilter nach Anspruch 1,
**dadurch gekennzeichnet,**
daß die Sammelschiene (15) in ihrem sägezahnförmigen Abschnitt unter einem Winkel von ca. ± 16° zur gewünschten Ausbreitungsrichtung der Oberflächenwellen bzw. zur Substratlängskante geneigt ist.

## FIG 1

## FIG 2

## FIG 3

Europäisches
Patentamt

**EUROPÄISCHER RECHERCHENBERICHT**

Nummer der Anmeldung

EP    90 12 3360

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| Y | PATENT ABSTRACTS OF JAPAN<br>vol. 4, no. 32 (E-2)(514) 19. März 1980<br>& JP-A-55 005 510 (TOKYO SHIBAURA DENKI ) 16.<br>Januar 1980<br>* das ganze Dokument *<br>--- | 1 | H03H9/145<br>H03H9/64 |
| Y | PATENT ABSTRACTS OF JAPAN<br>vol. 11, no. 257 (E-534)(2704) 20. August 1987<br>& JP-A-62 655 509 (MATSUSHITA ) 24. März 1987<br>* das ganze Dokument *<br>----- | 1 | |

**RECHERCHIERTE SACHGEBIETE (Int. Cl.5 )**

H03H

Der vorliegende Recherchenbericht wurde für alle Patentansprüche erstellt

| Recherchenort | Abschlußdatum der Recherche | Prüfer |
|---|---|---|
| DEN HAAG | 01 AUGUST 1991 | WRIGHT J.P. |

EPO FORM 1503 03.82 (P0403)